# EUROPÄISCHE PATENTANMELDUNG

(11) **EP 2 037 725 A2**
(43) Veröffentlichungstag der Anmeldung: **18.03.2009**
(21) Anmeldenummer: 08105152.6
(22) Anmeldetag: 27.08.2008
(51) Int. Cl.: H05K 13/04

(54) **Bestückkopf zum Bestücken von Substraten mit Bauelementen und Bestückautomat**

(30) Priorität: 14.09.2007 DE 102007043868
(71) Anmelder: Siemens Aktiengesellschaft, 80333 München (DE)
(72) Erfinder: Conrad, Robert, 82054, Sauerlach (DE); Mehdianpour, Mohammad, 81829, München (DE); Pfaffenberger, Werner, 83714, Miesbach (DE)

(57) **Zusammenfassung**

Es wird ein Bestückautomat (1) sowie ein Bestückkopf (6) zum Bestücken von Substraten (2) mit Bauelementen (3) für einen Bestückautomaten (1) beansprucht, welcher einen Stator (10) sowie einen am Stator (10) drehbar gelagerten Rotor (11) aufweist. Ferner weist der Bestückkopf mehrere Handhabungseinrichtungen (12) auf, welche am Rotor (11) angeordnet sind, sowie mindestens eine Arbeitseinrichtung (14), welche am Stator (10) angebracht ist, wobei die Handhabungseinrichtungen (12) derart schwenkbar am Rotor (11) angebracht sind, dass sie durch Schwenken in den Wirkbereich der mindestens einen Arbeitseinrichtung (14) bringbar sind. Da die Arbeitseinrichtung (14) am Bestückkopf (6) mitgeführt wird, muss sie nicht extra vom Bestückkopf (6) angefahren werden, wodurch sich die Verfahrwege des Bestückkopfs (6) reduzieren lassen, so dass eine höhere Bestückleistung erreichbar ist.

## Beschreibung

Die Erfindung betrifft einen Bestückkopf zum Bestücken von Substraten mit Bauelementen und einen Bestückautomaten mit einem derartigen Bestückkopf.

In der Bestücktechnik werden zum Bestücken von Substraten mit Bauelementen Bestückautomaten eingesetzt. Die Bauelemente werden durch seitlich am Bestückautomaten angeordnete Zuführeinrichtungen an definierten Abholpositionen bereitgestellt. Dort werden sie von einem Bestückkopf des Bestückautomaten abgeholt und in einen Bestückbereich transferiert, wo sie auf den Substraten positioniert werden. Zwischen dem Abholen der Bauelemente und dem Positionieren auf den Substraten werden die Bauelemente mit Hilfe geeigneter Erfassungseinrichtungen hinsichtlich ihrer Lage oder etwaiger Fehler überprüft.

Aus der EP 829 192 B1 ist ein Bestückautomat bekannt, welcher eine stationäre Kamera zur Erfassung von aufgenommenen Bauelementen aufweist. Die Vermessung der aufgenommenen Bauelemente erfolgt durch eine Verfahrbewegung des Bestückkopfs, welcher nach der Aufnahme der Bauelemente oberhalb der Kamera positioniert wird, so dass die Kamera die aufgenommenen Bauelemente von unten erfasst. Diese Art der Bauelementvermessung hat den Nachteil, dass die Verfahrwege des Bestückkopfs erhöht sind, weil der Bestückkopf nach der Aufnahme der Bauelemente nicht direkt zu dem zu bestückenden Substrat verfahren werden kann, sondern einen Umweg über den Erfassungsbereich der Kamera zurücklegen muss. Auf diese Weise wird die Bestückleistung, d.h. die maximale Anzahl an Bauelementen, die innerhalb einer bestimmten Zeiteinheit bestückt werden können, entsprechend reduziert.

Der Erfindung liegt die Aufgabe zugrunde, einen Bestückkopf und einen Bestückautomaten bereitzustellen, mittels derer die Bestückleistung erhöht werden kann.

Diese Aufgabe wird durch den Bestückkopf und den Bestückautomaten gemäß den unabhängigen Ansprüchen gelöst. Vorteilhafte Ausgestaltungen sind Gegenstand der abhängigen Ansprüche.

Der Bestückkopf zum Bestücken von Substraten mit Bauelementen gemäß Anspruch 1 weist einen Stator sowie einen am Stator drehbar gelagerten Rotor auf. Weiterhin verfügt der Bestückkopf über mehrere Handhabungseinrichtungen, welche am Rotor angeordnet sind, sowie mindestens eine Arbeitseinrichtung, welche am Stator angebracht ist. Die Handhabungseinrichtungen sind derart schwenkbar am Rotor angebracht, dass sie durch Schwenken in den Wirkbereich der mindestens einen Arbeitseinrichtung bringbar sind.

Die der Erfindung zugrunde liegende Idee ist darin zu sehen, die Arbeitseinrichtung als Teil des Bestückkopfs auszubilden, welche gemeinsam mit dem Bestückkopf verfahren wird. Die von den Handhabungseinrichtungen gehaltenen Bauelemente können durch Schwenken der Handhabungseinrichtungen in den Wirkbereich der Arbeitseinrichtung gebracht werden. Hieraus ergibt sich der Vorteil, dass die Arbeitseinrichtung, die beispielsweise als Kamera ausgebildet sein kann, nicht extra von dem Bestückkopf angefahren werden muss. Dadurch lassen sich zum einen die Verfahrwege reduzieren, zum anderen können Teilprozesse parallelisiert werden. Durch beide Effekte ist eine höhere Bestückleistung erreichbar. Ferner muss die mitgeführte Arbeitseinrichtung nicht unter den Bestückkopf verfahren werden. Durch das Ausschwenken der Handhabungseinrichtungen ist es möglich, die Bauelemente von unten zu analysieren, ohne dabei die Bauhöhe des Bestückkopfs zu erhöhen.

Als Arbeitseinrichtung kommen sowohl jegliche Art von Sensoren, wie beispielsweise optische oder elektronischer Erfassungseinrichtungen zur Bestimmung der Lage, der Anwesenheit oder sonstiger Inspektionen, als auch jedwede Art von Manipulationseinrichtungen, beispielsweise zum Drehen der Bauelemente, in Betracht.

In einer Ausgestaltung des Bestückkopfs nach Anspruch 2 ist die mindestens eine Arbeitseinrichtung als Arbeitsstation ausgebildet. Die Handhabungseinrichtungen sind dabei durch Drehen des Rotors nacheinander zu der Arbeitsstation bewegbar und können dort durch Ausschwenken in deren Wirkbereich gebracht werden.

Die sequentielle Zuführung der Handhabungseinrichtungen zu der Arbeitsstation hat den Vorteil, dass für jede Handhabungseinrichtung individuelle Einstellungen verwendet werden können. Beispielsweise kann im Fall der optischen Inspektion der Bauelemente die Beleuchtungssituation an die Oberfläche des jeweils zu untersuchenden Bauelements angepasst werden. Aus der erhöhten Flexibilität ergibt sich somit eine bessere Qualität und infolgedessen eine geringere Fehlerrate, was sich wiederum in einer höheren Bestückleistung widerspiegelt. Darüber hinaus ist mit der Ausgestaltung der Arbeitseinrichtung als Arbeitsstation ein geringerer konstruktiver Aufwand verbunden. Die Arbeitsstation kann dabei ortsfest am Stator des Bestückkopfs befestigt, aber auch drehbar angeordnet sein, so dass die Position der Arbeitsstation am Bestückkopf variiert werden kann. Ferner können auch mehrere Arbeitsstationen am Bestückkopf angeordnet sein.

In einer weiteren Ausgestaltung des Bestückkopfs nach Anspruch 3 sind die Handhabungseinrichtungen in radialer Richtung schwenkbar.

Beim Ausschwenken der Handhabungseinrichtungen in radialer Richtung können sich die Handhabungseinrichtungen durch ihre räumliche Anordnung nicht gegenseitig stören. Dies gilt vor allem für kleine und kompakte Bestückköpfe sowie für Bestückköpfe mit einer Vielzahl von Handhabungseinrichtungen. Daher ist das radiale Ausschwenken die bevorzugte Ausführungsform.

In einer Ausgestaltung des Bestückkopfs nach Anspruch 4 ist zum Schwenken der Handhabungseinrichtungen eine Kulissenführung ortsfest am Stator ausgebildet, so dass bei Drehung des Rotors die Handhabungseinrichtungen derart mit der Kulissenführung zusammenwirken, dass sie ausgelenkt werden.

Bei einer am Stator ortsfest ausgebildeten Führungskulisse handelt es sich um eine einfache, robuste und wenig störungsanfällige Ausführungsform für den Schwenkmechanismus.

In einer weiteren Ausgestaltung des Bestückkopfs nach Anspruch 5 weist der Bestückkopf mindestens einen Schwenkantrieb auf, mit dem die Handhabungseinrichtungen auslenkbar sind.

Hierdurch ergibt sich der Vorteil, dass der Bestückkopf kompakt gehalten werden kann. Der Schwenkantrieb muss dabei nicht ortsfest am Stator des Bestückkopfs angebracht sein, sondern kann drehbar angeordnet sein, so dass seine Position am Bestückkopf variierbar ist, so dass jede Handhabungseinrichtung individuell angefahren werden kann.

In einer Ausgestaltung des Bestückkopfs nach Anspruch 6 weist jede Handhabungseinrichtung einen individuellen Schwenkantrieb auf, mit dem jede Handhabungseinrichtung individuell auslenkbar ist.

Hieraus ergibt sich der Vorteil, dass jede Handhabungseinrichtung in jeder Position individuell ausgelenkt werden kann. Dadurch ist, vor allem im Zusammenspiel mit einer oder mehreren, nicht-ortsfest am Stator befestigten Arbeitsstation, ein hohes Maß an Flexibilität erreichbar.

Der Bestückautomat nach Anspruch 7 weist mindestens einem Bestückkopf gemäß einem der Ansprüche 1 bis 6 auf. Hinsichtlich der Vorteile dieses Bestückautomaten wird auf die Ausführungen zu den Ansprüchen 1 bis 6 verwiesen.

Im Folgenden wird die Erfindung anhand von Ausführungsbeispielen unter Bezug auf die beigefügten Figuren näher erläutert. In den Figuren sind:
- Figur 1: eine schematische Darstellung eines Bestückautoma- ten,
- Figuren 2a und 2b: ein erstes, schematisches Ausführungsbeispiel eines Bestückkopfs in Grund- und Aufriss
- Figur 3: ein zweites, schematisches Ausführungsbeispiel eines Bestückkopfs
- Figuren 4a und 4b: ein weiteres, schematisches Ausführungsbeispiel eines Bestückkopfs in Grund- und Aufriss

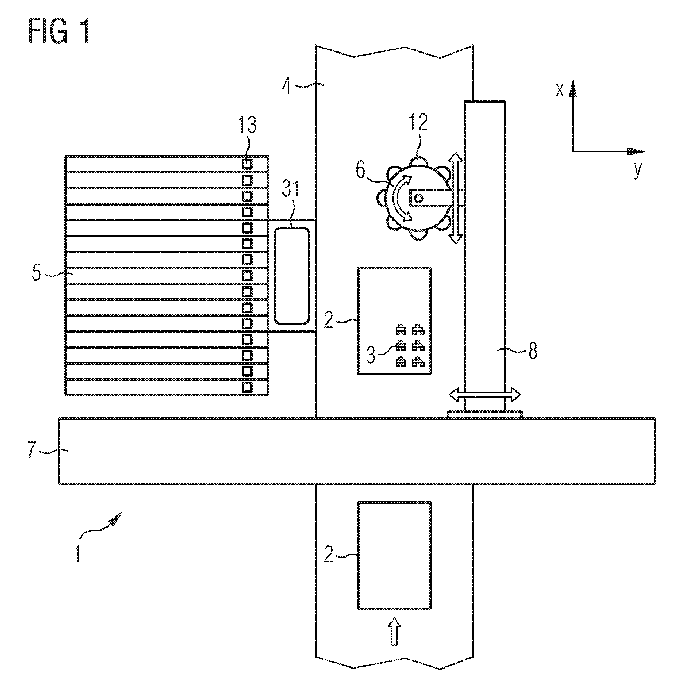

In Figur 1 ist ein Bestückautomat 1 zum Bestücken von Substraten 2 mit Bauelementen 3 in einer Draufsicht schematisch dargestellt. Der Bestückautomat 1 umfasst einen Querträger 7, welcher sich in einer y-Richtung erstreckt und fest mit einem Maschinengestell (nicht dargestellt) verbunden ist. Am Querträger 7 ist ein Portalarm 8 angebracht, welcher sich in x-Richtung erstreckt und in y-Richtung verschiebbar am Querträger 7 befestigt ist. Querträger 7 und Portalarm 8 bilden zusammen die Positioniervorrichtung, wobei durch die x-Achse und die y-Achse ein orthogonales Bezugssystem gebildet wird. Am Portalarm 8 ist ein Bestückkopf 6 in x-Richtung verschiebbar angebracht, welche über mehrere Handhabungseinrichtungen 12 zum Handhaben der Bauelemente 3 verfügt. Weiterhin ist eine Transportvorrichtung 4 zum Transport der Substrate 2 in einen Bestückbereich des Bestückautomaten 1 vorgesehen. Seitlich der Transportvorrichtung 4 sind Zuführvorrichtungen 5 in einem Abholbereich des Bestückautomaten 1 angeordnet, mittels derer die Bauelemente 3 an jeweils zugeordneten Abholpositionen 13 bereitgestellt werden. Dort werden sie von dem Bestückkopf 6 mittels der Handhabungseinrichtungen 12 abgeholt und in den Bestückbereich des Bestückautomaten 1 transferiert, wo sie auf dem Substrat 2 positioniert werden. Zwischen dem Abholbereich und dem Bestückbereich ist eine Überprüfungseinrichtung 31 zur Überprüfung der Lage der Bauelemente 3 angeordnet.

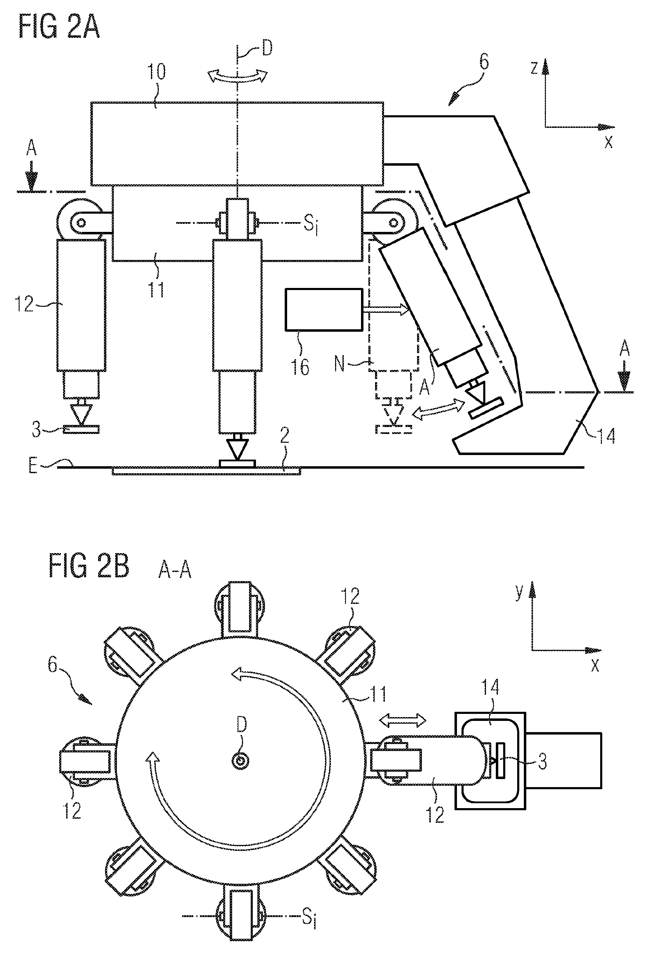

Die Figuren 2a und 2b zeigen ein erstes, schematisches Ausführungsbeispiel eines Bestückkopfs 6 in Grund- und Aufriss. Der Bestückkopf 6 verfügt über einen Stator 10, mittels dem er an dem Positioniersystem 7, 8 (siehe Figur 1) befestigt ist. Ferner weist der Bestückkopf 6 einen Rotor 11 auf, welcher am Stator 10 um die Drehachse D drehbar gelagert ist. Am Umfang des Rotors 11 sind mehrere Handhabungseinrichtungen 12 zum Handhaben von Bauelementen 3, beispielsweise mittels mechanischer Greifer oder Sauggreifer, befestigt. Am Stator 10 ist ferner eine Arbeitsstation 14 befestigt. Diese ist im vorliegenden Ausführungsbeispiel als optische Inspektionseinrichtung ausgeführt. Sie kann jedoch auch andere Funktionen, beispielsweise zur Manipulation der Drehlage der gehaltenen Bauelemente, beinhalten. Weiterhin weist der Bestückkopf 6 einen Schwenkantrieb 16 auf, mittels dem die Handhabungseinrichtungen 12 geschwenkt und somit in den Wirkbereich der Arbeitsstation 14 gebracht werden können.

Mit Drehung des Rotors 11 werden die Handhabungseinrichtungen 12 nacheinander zu der Arbeitsstation 14 bewegt. Die Handhabungseinrichtungen 12 sind an ihrem oberen Ende schwenkbar gelagert, so dass sie um ihre jeweilige Schwenkachse Sᵢ in radialer Richtung, bezogen auf die Drehachse D des Rotors 11, aus einer Normalposition N (gestrichelt dargestellt) in eine Arbeitsposition A geschwenkt werden können. In der Normalposition N, in der sich die Bauelemente 3 nicht im Wirkbereich der Arbeitsstation 14 befinden, können beispielsweise Bauelemente 3 aufgenommen oder abgesetzt werden. Dabei ist jedem Bauelement 3 eine Handhabungseinrichtung 12 eindeutig zugeordnet. An der Arbeitsstation 14 kann ein gehaltenes Bauelement 3 mittels des Schwenkantriebs 16 durch einfaches Schwenken der jeweiligen Handhabungseinrichtung 12 in die Arbeitsposition A, d.h. in den Wirkbereich der Arbeitsstation 14, gebracht werden. Im Falle der optischen Inspektionseinrichtung entspricht der Wirkbereich der Fokusebene der Kamera. In dieser Arbeitsposition A wird die Lage des mitgeführten Bauelements 3 relativ zu seiner Handhabungseinrichtung 12 vermessen. Anschließend wird der Rotor 11 weitergedreht, und die Handhabungseinrichtung 12 des gerade vermessenen Bauelements 3 wird mittels des Schwenkantriebs 16 wieder in ihre Normmalposition N zurückgeschwenkt. Währenddessen kann beispielsweise die Drehlage des Bauelements 3 an der entsprechenden Handhabungseinrichtung 12 korrigiert werden. Mit Weiterdrehen des Rotors 11 wird automatisch die nächste Halteeinrichtung in den Wirkbereich der Arbeitsstation 14 verfahren. Während des Inspektionsvorgangs kann der Bestückkopf 6 in x-y-Richtung zum Substrat 2 verfahren werden, was einem Parallelisieren der beiden Teilprozesse entspricht. Befindet sich die Handhabungseinrichtung 12 wieder in ihrer Normalposition N und ist der Bestückkopf 6 in x-y-Richtung entsprechend über der Bestückposition des Bauelements 3 positioniert, so kann das gehaltene Bauelement 3 durch eine Zustellbewegung der Handhabungseinrichtung 12 in einer z-Richtung auf dem Substrat 2 abgesetzt werden.

Auf diese Weise kann durch einfaches Schwenken der jeweiligen Handhabungseinrichtung 12 jedes Bauelement 3 auf dem Verfahrweg des Bestückkopfs 6 zwischen Abholen und Absetzen der Bauelemente 3 in den Wirkbereich der Arbeitsstation 14 gebracht werden. Prinzipiell ist es ebenso möglich, die Arbeitsstation 14 um die Drehachse D drehbar am Stator anzubringen, um eine höhere Flexibilität zu erreichen.

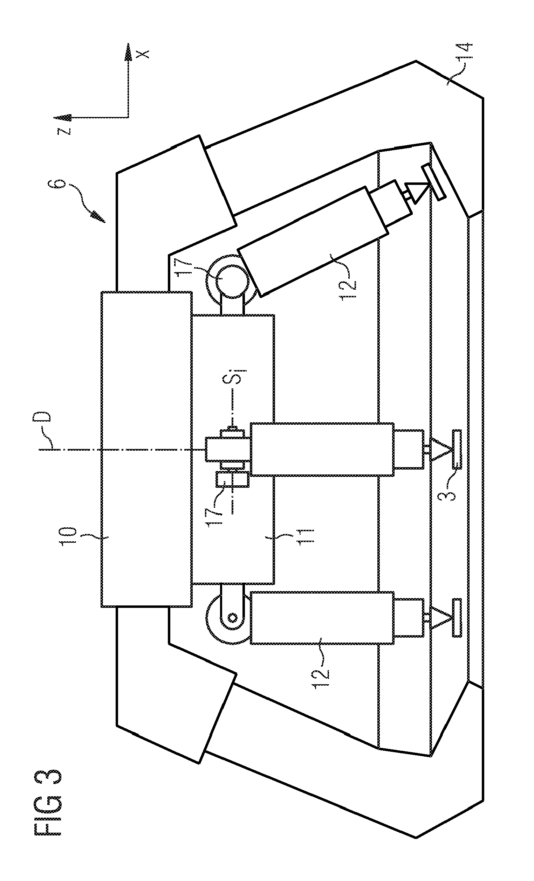

Figur 3 zeigt ein zweites schematisches Ausführungsbeispiel des Bestückkopfs 6 in einer Teilschnitt-Darstellung. Im Unterschied zu dem in den Figuren 2a und 2b dargestellten Ausführungsbeispiel ist die Arbeitseinrichtung 14 dabei nicht als Station, welche an einer bestimmten Stelle am Stator angeordnet ist, ausgebildet. Hier ist die Arbeitseinrichtung 14 ringförmig umlaufend am Stator ausgebildet, so dass sie die Handhabungseinrichtungen 12 über den gesamten Umfang des Rotors 11 umgibt. Hieraus ergibt sich der Vorteil, dass jedes Bauelement 3 in jeder Rotorstellung durch Ausschwenken der jeweiligen Handhabungseinrichtung 12 in den Wirkbereich der Arbeitseinrichtung 14 gebracht werden kann. Dies geschieht mit Hilfe von Einzelschwenkantrieben 17, wobei jeder Handhabungseinrichtung 12 ein eigener Einzelschwenkantrieb 17 individuell zugeordnet ist. Damit kann jede Handhabungseinrichtung 12 durch Ausschwenken in die Arbeitsposition A und wieder zurück in die Normalposition N gebracht werden. Bauelemente 3 können somit an jeder beliebigen Position des Rotors inspiziert werden.

In Figur 3 ist daher eine Handhabungseinrichtung 12 in einem ausgeschwenkten Zustand dargestellt, wohingegen die übrigen Handhabungseinrichtungen 12 in ihrer jeweiligen Normalposition dargestellt sind, in der sie beispielsweise Bauelemente 3 aufnehmen oder absetzen können. Mit Hilfe der dargestellten Ausgestaltung der Arbeitseinrichtung 14 kann beispielsweise eine gleichzeitige Anwesenheitskontrolle für alle aufgenommenen Bauelemente 3 durchgeführt werden. Ebenso ist es möglich, die relative Drehlage der Bauelemente 3 zu ihrer jeweiligen Handhabungseinrichtung 12 gleichzeitig zu bestimmen.

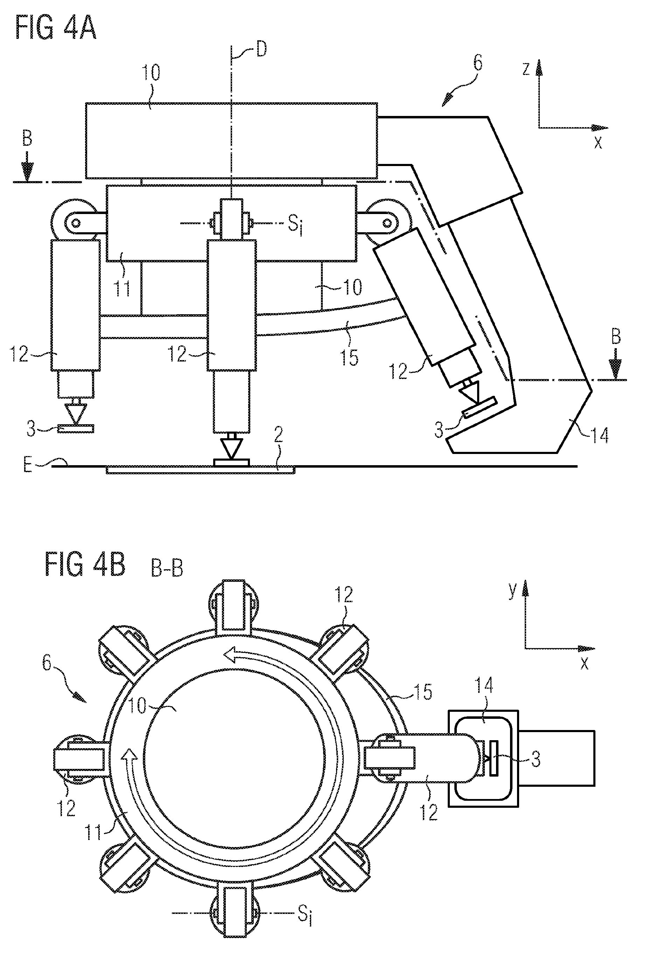

In den Figuren 4a und 4b ist ein weiteres Ausführungsbeispiel eines Bestückkopfs 6 in Grund- und Aufriss dargestellt. Dieses unterscheidet sich von den beiden zuvor beschriebenen Ausführungsbeispielen in der Art des Schwenkmechanismus für die Handhabungseinrichtungen 12. Das Ausschwenken der Handhabungseinrichtungen 12 wird hier über eine Ablaufkurve 15 realisiert. Die Ablaufkurve 15 ist am Stator 10 befestigt und umlaufend ausgebildet. Bei Drehung des Rotors 11 um die Drehachse D gleiten die Handhabungseinrichtungen 12 an der Lauffläche der Ablaufkurve 15 entlang. Dabei werden sie von der Lauffläche in dem Bereich, in dem die Ablaufkurve auskragt, in radialer Richtung, senkrecht zur Drehachse D, ausgelenkt, wie in den Figuren 4a und 4b rechts dargestellt. In diesem Bereich ist auch die Arbeitseinrichtung 14 angeordnet, welche hier wiederum als Arbeitsstation zur optischen Inspektion der Bauelemente 3 ausgebildet ist. Werden die Handhabungseinrichtungen 12 durch Drehen des Rotors 11 an der Arbeitsstation 14 vorbeigeführt, schwenken sie aufgrund der Wechselwirkung mit der Ablaufkurve 15 automatisch aus und werden somit in den Wirkbereich der Arbeitsstation 14 gebracht, wo sie hinsichtlich ihrer relativen Lage vermessen werden. Anschließend wird die jeweilige Handhabungseinrichtungen 12 durch Drehung des Rotors 11 weitergeführt und schwenkt automatisch wieder zurück in ihre Normalposition. Das Rückschwenken in die Normalposition kann beispielsweise über eine Rückstellfeder (nicht dargestellt) im Schwenkgelenk der Handhabungseinrichtung 12 erfolgen.

Es ist jedoch ebenfalls möglich, die Ablaufkurve 15 als Führungskulisse so auszugestalten, dass die Handhabungseinrichtungen 12 bei Drehung des Rotors 11 in einem ovalen Schlitz der Kulisse sowohl beim Ausschwenken als auch beim Rückschwenken geführt werden. Eine Rückstellfeder ist damit nicht mehr nötig.

Um die Gleitreibung zwischen der Lauffläche der Ablaufkurve 15 und der Mantelflächen der Handhabungseinrichtungen 12 zu reduzieren, können auch Rollkörper (nicht dargestellt) verwendet werden, die an den Mantelflächen der Handhabungseinrichtungen 12 angeordnet sind und sich bei Drehung des Rotors 11 auf der Lauffläche der Ablaufkurve 15 abwälzen.

Die Gestaltung des Schwenkmechanismus als Ablaufkurve 15 hat den Vorteil, dass es sich dabei um eine rein mechanische Konstruktion handelt, welche sowohl kompakt als auch einfach, preiswert und robust ist. Allein durch die Form der Ablaufkurve 15 werden die Handhabungseinrichtungen 12 in den Wirkbereich der Arbeitsstation 14 gebracht. Auf zusätzliche Schwenkantriebe sowie deren entsprechende Ansteuerung kann in diesem Fall verzichtet werden.

### Bezugszeichenliste

- 1: Bestückautomat
- 2: Substrat
- 3: Bauelement
- 4: Transportvorrichtung
- 5: Zuführeinrichtung
- 6: Bestückkopf
- 7: Querträger
- 8: Portalarm

- 10: Stator
- 11: Rotor
- 12: Handhabungseinrichtung
- 13: Abholposition
- 14: Arbeitseinrichtung
- 15: Ablaufkurve
- 16: Schwenkantrieb
- 17: Einzelschwenkantrieb

- 31: Überprüfungseinrichtung

- T: Transportrichtung
- E: Substratebene
- D: Drehachse des Bestückkopfs
- S: Schwenkachse
- A: Arbeitsposition
- N: Normalposition

## Patentansprüche

1. Bestückkopf (6) zum Bestücken von Substraten (2) mit Bauelementen (3) für einen Bestückautomaten (1), mit
- einem Stator (10),
- einem Rotor (11), welcher am Stator (10) drehbar gelagert ist,
- mehreren Handhabungseinrichtungen (12), welche am Rotor (11) angeordnet sind,
- mindestens einer Arbeitseinrichtung (14), welche am Stator (10) angebracht ist,
**dadurch gekennzeichnet,**
- **dass** die Handhabungseinrichtungen (12) schwenkbar am Rotor (11) angebracht sind, derart, dass sie durch Schwenken in den Wirkbereich der mindestens einen Arbeitseinrichtung (14) bringbar sind.

2. Bestückkopf (6) nach Anspruch 1,
**dadurch gekennzeichnet,**
**dass** die mindestens eine Arbeitseinrichtung (14) als Arbeitsstation ausgebildet ist, wobei die Handhabungseinrichtungen (12) durch Drehen des Rotors (11) nacheinander zu der Arbeitsstation bewegbar sind und dort durch Schwenken in deren Wirkbereich bringbar sind.

3. Bestückkopf (6) nach einem der Ansprüche 1 oder 2,
**dadurch gekennzeichnet,**
**dass** die Handhabungseinrichtungen (12) in radialer Richtung schwenkbar sind.

4. Bestückkopf (6) nach einem der Ansprüche 1 bis 3,
**dadurch gekennzeichnet,**
**dass** zum Schwenken der Handhabungseinrichtungen (12) eine Ablaufkurve (15) ortsfest am Stator (10) ausgebildet ist, so dass bei Drehung des Rotors (11) die Handhabungseinrichtungen (12) derart mit der Ablaufkurve(15) zusammenwirken, dass sie ausgelenkt werden.

5. Bestückkopf (6) nach einem der Ansprüche 1 bis 3,
**dadurch gekennzeichnet,**
**dass** der Bestückkopf (6) mindestens einen Schwenkantrieb (16) aufweist, mit dem die Handhabungseinrichtungen (12) auslenkbar sind.

6. Bestückkopf (6) nach einem der Ansprüche 1 bis 3,
**dadurch gekennzeichnet,**
**dass** jede Handhabungseinrichtung (12) einen eigenen individuellen Schwenkantrieb (17) aufweist, mit dem jede Handhabungseinrichtung (12) individuell auslenkbar ist.

7. Bestückautomat (1) mit mindestens einem Bestückkopf (6) nach einem der Ansprüche 1 bis 6.
